# FASCICULE DE BREVET EUROPEEN

(11) **EP 4 181 638 B1**
(45) Date de publication et mention de la délivrance du brevet: **06.05.2026**
(21) Numéro de dépôt: 22206317.4
(22) Date de dépôt: 09.11.2022
(51) Int. Cl.: H05K 3/46, H01P 1/387, H05K 3/00

(54) **PROCÉDÉ DE FABRICATION AMÉLIORÉ D'UN CIRCULATEUR À FERRITE INTÉGRÉ DANS UNE CARTE MULTICOUCHE**
VERBESSERTES HERSTELLUNGSVERFAHREN FÜR EINEN IN EINER MEHRSCHICHTIGEN KARTE INTEGRIERTEN FERRITZIRKULATOR
IMPROVED MANUFACTURING METHOD FOR FERRITE CIRCULATOR INTEGRATED IN MULTILAYER BOARD

(30) Priorité: 10.11.2021 FR 2111935
(43) Date de publication de la demande: 17.05.2023
(73) Titulaire: THALES, 92400 Courbevoie (FR)
(72) Inventeur: KERTESZ, Philippe, 78851 ELANCOURT CEDEX (FR); CABAN-CHASTAS, Daniel, 33700 MERIGNAC (FR)
(74) Mandataire: Lavoix

(56) Documents cités:
- JP-B1- 6 275 359
- KR-B1- 101 914 014
- US-B1- 6 611 180

## Description

La présente invention a pour domaine général celui des antennes réseaux, qui sont des antennes constituées de l'assemblage d'une pluralité d'antennes élémentaires.

Plus précisément, la présente invention concerne une méthode d'intégration d'un circulateur à ferrite dans un composant laminé comportant un empilement de couches conductrices et isolantes, ledit composant pouvant offrir avantageusement d'autres fonctionnalités, notamment celle d'élément rayonnant d'une antenne élémentaire.

Le document KR 101 914 014 B1 présente un circulateur comportant un premier aimant et un second aimant, une ferrite étant interposée entre ces deux aimants.

Le document JP 6 275359 B1 divulgue un procédé permettant la fabrication d'un unique circulateur à ferrite à la fois.

Le document US 6 611 180 B1 divulgue un procédé de fabrication d'une pluralité de circulateurs à ferrite simultanément. Ce procédé prévoit de préparer une carte de circulateur, dont une couche conductrice a été gravée pour créer une pluralité de motifs appelés cellules gyromagnétiques (aussi dénommés pistes en « Y » dans le présent document, puisque leur géométrie rappelle celle d'un « Y »). Ce procédé prévoit par ailleurs de préparer une pluralité d'éléments, chaque élément résultant du collage d'un aimant sur un disque de ferrite, de préparer une carte de support, dont une face présente une pluralité d'évidements, et d'emmancher à force chaque élément aimant/disque de ferrite dans un évidement correspondant pour obtenir un assemblage. Enfin, ce procédé prévoit l'empilage de cet assemblage sur la carte de circulateur, de sorte que chaque élément aimant/disque soit disposé en regard d'une piste en « Y » pour constituer un circulateur à ferrite. Enfin, une étape de pressage et collage à chaud permet d'obtenir un circuit multicouche intégrant un circulateur à ferrite.

Ce procédé de l'état de la technique présente différents inconvénients. Le premier inconvénient réside dans le fait de ne pas garantir une bonne continuité électrique entre une cellule gyromagnétique et le disque de ferrite de l'élément aimant/disque associé. En effet, il existe un risque élevé qu'un interstice résiduel subsiste autour de la cellule gyromagnétique, notamment entre la cellule gyromagnétique et le disque de ferrite, entrainant une diminution des performances, voire une forte perturbation de l'effet gyromagnétique (effet sur lequel est fondé le fonctionnement d'un circulateur à ferrite).

En effet, l'incertitude de fabrication sur l'épaisseur d'un disque de ferrite, ainsi que l'incertitude de fabrication de la profondeur de l'évidement recevant ce disque de ferrite dans la carte de support, font que la face transversale du disque de ferrite en vis-à-vis de la cellule gyromagnétique peut se situer à l'écart de celle-ci et non pas en contact direct avec celle-ci.

Le deuxième inconvénient associé au procédé de fabrication de l'art antérieur est lié aux tolérances mécaniques dans le plan XY, des différentes étapes de réalisation proposées.

Le positionnement des ferrites en les insérant à force dans des évidements aménagés par usinage dans une couche organique de la carte de support induit un premier risque de décentrage avec le reste du circulateur (c'est-à-dire avec la cellule gyromagnétique) lié à la tolérance en XY de ces évidements.

L'empilage de l'assemblage sur la carte de circulateur induit un deuxième risque de décentrage dans le plan XY, car il faut aligner l'assemblage portant les éléments aimant/disque de ferrite avec la carte de circulateur portant les cellules gyromagnétiques : cette opération est généralement réalisée par l'utilisation de pions de concordance, dont le positionnement est réalisé par perçage de trous qui présentent eux aussi des imprécisions de positionnement dans le plan XY.

Enfin, le pressage et le collage de l'assemblage sur la carte de circulateur induit un troisième risque de décentrage dans le plan XY. Malgré la présence des pions de concordance, les matériaux se dilatent différemment les uns par rapport aux autres, ce qui dégrade la qualité de l'empilage.

Or, il est nécessaire d'avoir un très bon alignement des composants pour un fonctionnement optimal du circulateur ainsi fabriqué.

En conséquence, le procédé de fabrication de l'art antérieur ne garantit pas d'obtenir des circulateurs performants, c'est-à-dire présentant l'effet gyromagnétique dans une bande de fréquence donnée, des pertes faibles et une isolation maximale entre voies.

Le but de la présente invention est de résoudre ces problèmes.

Pour cela l'invention a pour objet un procédé de fabrication selon les revendications annexées.

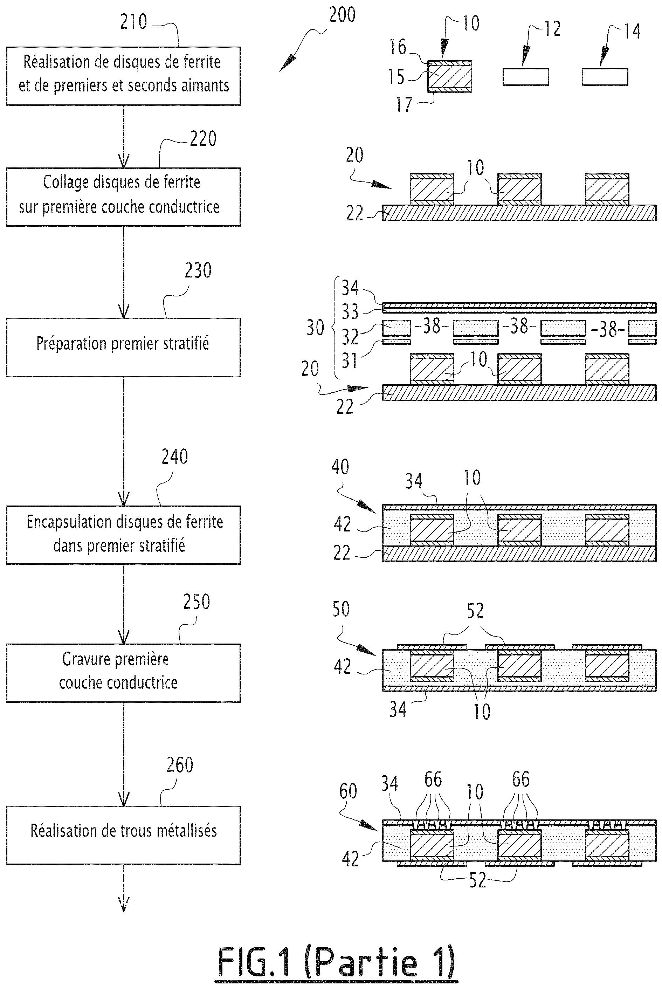

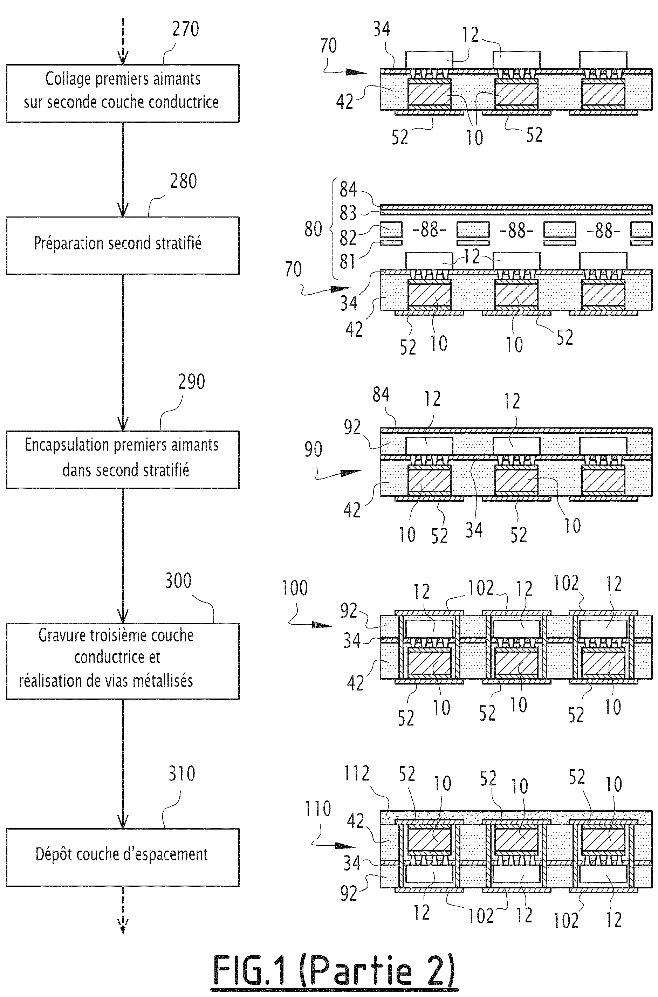

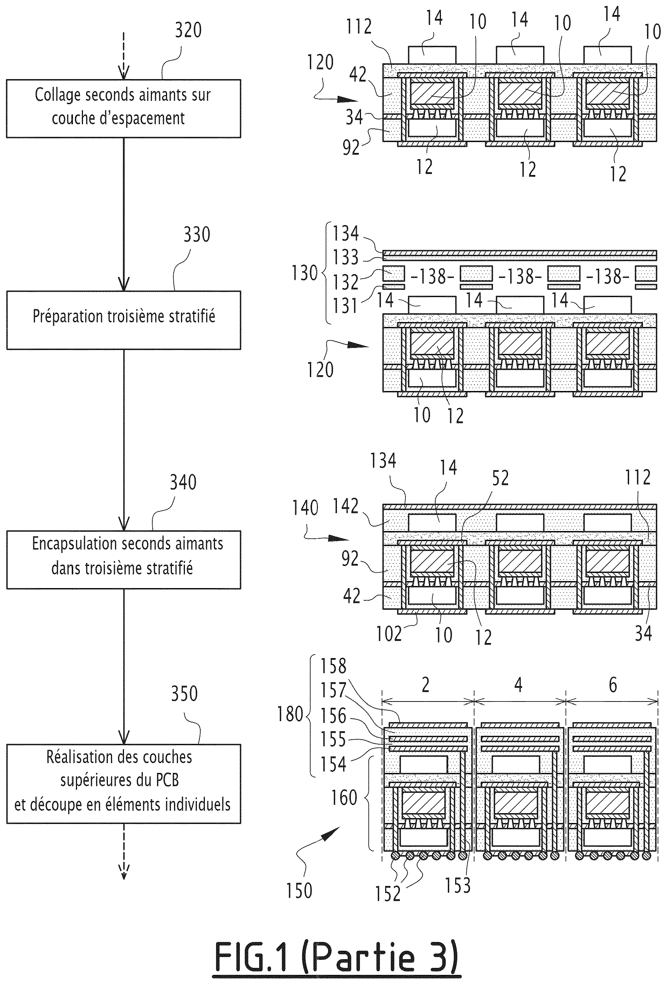

L'invention et ses avantages seront mieux compris à la lecture de la description détaillée qui va suivre d'un mode de réalisation particulier, donné uniquement à titre d'exemple non limitatif, cette description étant faite en se référant à l'unique figure, qui s'étend sur trois planches, illustrant un mode de réalisation préféré du procédé de fabrication selon l'invention, chaque étape du procédé, représentée sur la gauche de la figure, conduisant à un composant, représenté en coupe sur la droite de la figure.

### Généralités

Selon l'invention, chaque disque de ferrite est d'abord fixé précisément (en position et en continuité électrique) sur la couche conductrice portant les motifs gyromagnétiques ou pistes en « Y », avant d'être encapsulé dans un stratifié multicouche adapté de manière à garantir une parfaite maîtrise dimensionnelle de la structure magnétique fabriquée, notamment de la continuité entre la ferrite et la piste conductrice et l'alignement ferrite / cellule gyromagnétique / aimant, et, par conséquent, les caractéristiques du circulateur fabriqué.

### Mode de réalisation préféré du procédé de fabrication

Un mode de réalisation particulier du procédé de fabrication 200 va être présenté en référence aux première, seconde et troisième partie de la figure annexée.

### Etape 210

L'étape 210 consiste à préparer une pluralité de N disques de ferrite 10 ainsi qu'une pluralité de N premiers aimants 12 et N seconds aimants 14.

Chaque disque de ferrite 10 est constitué d'une céramique de ferrite 15 de forme cylindrique, dont les faces transversales sont respectivement recouvertes de films conducteurs, par exemple en or, référencés 16 et 17 sur la figure.

Les céramiques de ferrite sont réalisées par des procédés de frittage céramique et triées après fabrication, pour garantir des tolérances dimensionnelles maîtrisées.

De même, les aimants sont triés après fabrication, pour garantir les tolérances dimensionnelles requises.

### Etape 220

L'étape 220 consiste à coller la pluralité de disques de ferrite 10 en surface sur une première couche conductrice 22 afin d'obtenir un composant 20.

La première couche 22 est de préférence en cuivre.

La première couche 22 est rigide. Plus précisément, elle présente une épaisseur suffisante pour lui conférer une rigidité évitant toute déformation lors de la mise en œuvre de l'étape de collage 220.

Si elle est réalisée en cuivre, la première couche conductrice 22 présente typiquement une épaisseur entre 35 et 75 µm.

La face de la première couche conductrice 22 devant recevoir les disques de ferrite 10 est recouverte d'une colle conductrice adaptée.

Pour l'implantation des disques de ferrite 10, une machine bras-transfert (« pick and place machine » en anglais) est utilisée. Une telle machine possède un bras robotisé pouvant être programmé pour transférer un disque de ferrite d'une zone de stockage jusqu'à un emplacement prédéfini sur la première couche conductrice 22, avec une très grande précision et répétabilité.

Chaque disque de ferrite 10 est ainsi placé en une position précise par rapport à un repère de référence lié au composant.

De plus, une continuité électrique est établie de manière certaine entre la première couche conductrice 22 et la céramique de ferrite 15. Il n'existe aucun interstice résiduel entre les surfaces en vis-à-vis risquant de dégrader l'effet gyromagnétique sur lequel se fonde le fonctionnement d'un circulateur à ferrite.

### Etape 230

L'étape 230 consiste à préparer les constituants d'un premier stratifié 30 destiné à encapsuler les disques de ferrite 10 du composant 20.

Le premier stratifié 30 est par exemple un stratifié simple face constitué d'un empilement de couches comportant successivement : une première couche de pré-imprégné 31, une couche de plastique 32, une seconde couche de pré-imprégné 33 et une couche externe de cuivre (avantageusement supportée par une couche de plastique), dite seconde couche conductrice 34.

Les pré-imprégnés comportent un renfort fibreux (fibre de verre) mélangé à un polymère thermodurcissable dans un état métastable (pré-réticulé).

Le plastique dont est fait la première couche de plastique 32 est sélectionné pour présenter une permittivité diélectrique maximale (typiquement supérieure à 6), de manière à pouvoir réaliser des interconnexions à impédance contrôlée les plus compactes possibles.

La face du premier stratifié 30 opposée à la seconde couche conductrice 34 présente une pluralité de trous borgnes 38. Chaque trou borgne est destiné à recevoir un disque de ferrite 10. Un trou borgne 38 traverse la première couche de pré-imprégné 31 et la première couche plastique 32, mais pas la seconde couche de pré-imprégné 33, ni la seconde couche conductrice 34.

Le diamètre de chaque trou borgne 38 est plus important que le diamètre nominal d'un disque de ferrite 10 de manière à contenir les disques de ferrite sans être en contact avec eux, avec des intervalles minimums, pour compenser toute dispersion sur cette cote lors de la fabrication des disques de ferrites 10, ainsi que sur le positionnement de chaque ferrite par rapport à chaque trou borgne 38.

### Etape 240

L'étape 240 est l'étape d'encapsulation proprement dite conduisant au composant 40. Le premier stratifié 30 est approché par au-dessus de la première couche conductrice 22 portant les disques de ferrites 10 de manière à loger chacun d'entre eux dans un trou borgne correspondant.

Puis, une opération de pressage sous vide et à température élevée (typiquement aux environs de 200°C) provoquant la polymérisation des couches 31 et 33 est réalisée pour assurer la prise du premier stratifié 30, son collage sur la première couche conductrice 22 et sur la face supérieure de chaque disque de ferrite 10.

Une couche isolante 42 homogène est ainsi réalisée.

Il est à noter que le pressage permet de forcer le polymère des première et seconde couches de pré-imprégné, 31 et 33, dans les intervalles latéraux existants entre un disque de ferrite 10 et le trou borgne 38 le recevant. Ainsi, la céramique de ferrite 15 est en contact sur toute sa face latérale avec le matériau de la couche isolante 42.

La présence de la seconde couche de pré-imprégné 33, qui est une couche continue, permet de compenser les éventuelles dispersion de fabrication sur l'épaisseur des disques de ferrite 10. Ainsi, la distance entre les première et seconde couches conductrices, 22 et 34, est maîtrisée.

### Etape 250

Après retournement du composant pour que la première couche 22 soit accessible par au-dessus, l'étape 250 consiste à travailler la première couche conductrice 22 de manière à obtenir un composant intermédiaire 50.

Selon l'invention, la première couche conductrice 22 est amincie pour en réduire l'épaisseur à moins de 40 µm, c'est-à-dire à une épaisseur similaire à celle de la seconde couche conductrice 34.

La première couche conductrice 22 est gravée pour y former une pluralité de cellules gyromagnétique ou pistes en forme de « Y », chaque piste en « Y » 52 étant au droit d'un disque de ferrite 10 associé. Les extrémités d'une piste en « Y » sont destinées à être connectées respectivement à la voie d'émission, à la voie de réception, et à l'élément rayonnant d'une antenne élémentaire.

Des techniques connues de gravure chimique avec des masques de forme adaptée sont ici mises en oeuvre.

### Etape 260

Après retournement du composant pour que la seconde couche conductrice 34 soit accessible par au-dessus, l'étape 260 consiste à percer la seconde couche conductrice 34 d'une pluralité de perçages allant jusqu'au film conducteur en surface de chaque disque de ferrite 10. Chaque perçage est ensuite métallisé par voie électrochimique pour réaliser un via 66 connectant électriquement la seconde couche conductrice 34 et chaque disque de ferrite 10.

On utilise ici par exemple un laser focalisé pour réaliser les perçages.

Un composant 60 est ainsi obtenu pour lequel une continuité électrique est réalisée entre la seconde couche conductrice 34 et chaque disque de ferrite 10.

### Etape 270

L'étape 270 consiste à coller la pluralité de premiers aimants 12 sur la surface exposée de la seconde couche conductrice 34 afin d'obtenir un composant intermédiaire 70.

La surface devant recevoir les premiers aimants 12 est recouverte d'une colle adaptée.

Pour l'implantation des premiers aimants 12, une machine bras-transfert (« pick and place machine » en anglais) est utilisée. Chaque premier aimant 12 est ainsi placé en une position précise par rapport à un repère de référence lié au composant.

Un premier aimant 12 est disposé de manière à être au droit d'un disque de ferrite 10 correspondant.

### Etape 280

L'étape 280 consiste à préparer les constituants d'un second stratifié 80 destiné à encapsuler les premiers aimants du composant 70.

Le second stratifié 80 est par exemple un stratifié simple face constitué d'un empilement de couches comportant successivement : une première couche de pré-imprégné 81, une couche de plastique 82, une seconde couche de pré-imprégné 83 et une couche externe de cuivre (avantageusement supportée par une couche de plastique), dite troisième couche conductrice 84.

Les pré-imprégnés comportent un renfort fibreux (fibre de verre) mélangé à un polymère thermodurcissable dans un état métastable (pré-réticulé).

Le plastique dont est fait la couche de plastique 82 est sélectionné pour présenter une permittivité diélectrique maximale (typiquement supérieure à 6), pour les mêmes raisons que celles indiquées précédemment.

La face du second stratifié 80 opposée à la troisième couche conductrice 84 présente une pluralité de trous borgnes 88. Chaque trou borgne 88 est destiné à recevoir un premier aimant 12. Un trou borgne 88 traverse la première couche de pré-imprégné 81 et la couche plastique 82, mais pas la seconde de pré-imprégné 83, ni la troisième couche conductrice 84.

Le diamètre de chaque trou borgne 88 est plus important que le diamètre nominal d'un premier aimant 12, de manière à ce que ce dernier soit contenu dans le trou borgne correspondant sans être en contact avec celui-ci. Il est donc ménagé un intervalle latéral minimum pour tenir compte des dispersions de fabrication sur le diamètre des premiers aimants, ainsi que sur la position de chaque aimant par rapport à chaque trou borgne 88.

### Etape 290

L'étape 290 est une étape d'encapsulation permettant d'obtenir un composant intermédiaire 90 au cours de laquelle le second stratifié 80 est approché par au-dessus de la seconde couche conductrice 34 portant les premiers aimants 12 de manière à loger chacun d'entre eux dans un trou borgne 88 correspondant.

Pour provoquer la polymérisation des couches 81 et 83, une opération de pressage sous vide et à température élevée (typiquement aux environs de 200°C) est réalisée conduisant à la prise du second stratifié 80, son collage sur la seconde couche conductrice 34 et sur la face supérieure de chaque premier aimant 12. Une couche isolante 92 homogène est ainsi réalisée.

Le pressage permet de forcer le polymère des première et seconde couches de pré-imprégné, 81 et 83, dans les intervalles latéraux existants entre un premier aimant 12 et le trou borgne 88 le recevant. Ainsi, l'aimant est en contact sur toute sa face latérale avec le matériau de la couche isolante 92.

La présence de la seconde couche de pré-imprégné 83, qui est une couche continue, permet de compenser les éventuelles dispersion de fabrication sur la hauteur des premiers aimants 12. Ainsi, la distance entre les seconde et troisième couches conductrices, 34 et 84, est maîtrisée.

### Etape 300

L'étape 300 consiste à travailler la troisième couche conductrice 84 pour y délimiter des pistes ou des plages en cuivre 102 au droit de chaque disque de ferrite 12, qui permettront la réalisation de connexions électriques entre le composant élémentaire obtenu et l'équipement dans lequel celui-ci sera intégré.

Des techniques connues de gravure chimique avec des masques de forme adaptée sont ici mises en œuvre.

Des vias métallisés 104 sont ensuite réalisés entre chaque pistes 102 et la piste en « Y » 52 correspondante.

Le perçage des vias est réalisé par laser.

Le composant 100 est obtenu à l'issue de cette étape.

### Etape 310

Après retournement du composant intermédiaire 100 pour que les pistes en « Y » 52 soient accessibles par au-dessus, l'étape 310 consiste à déposer une couche d'espacement 112 à la surface exposée des pistes en « Y » 52 pour réaliser un composant intermédiaire 110.

### Etape 320

L'étape 320 consiste à coller la pluralité de seconds aimants 14 sur la surface exposée de la couche d'espacement 112 pour obtenir le composant 120.

La surface de la couche d'espacement 112 devant recevoir les seconds aimants 14 est recouverte d'une colle adaptée.

Pour l'implantation des seconds aimants 14, une machine bras-transfert (« pick and place machine » en anglais) est utilisée. Chaque second aimant 14 est ainsi placé en une position précise par rapport à un repère de référence lié au composant. Un second aimant 14 est disposé de manière à être au droit d'un disque de ferrite 10 correspondant.

### Etape 330

L'étape 330 consiste à préparer les constituants d'un troisième stratifié 130 destiné à encapsuler les seconds aimants 14 du composant 120.

Le troisième stratifié est par exemple un stratifié simple face constitué d'un empilement de couches comportant successivement : une première couche de pré-imprégné 131, une couche de plastique 132, une seconde couche de pré-imprégné 133 et une couche externe de cuivre (avantageusement supportée par une couche de plastique), dite quatrième couche conductrice 134.

Les pré-imprégnés comportent un renfort fibreux (fibre de verre) mélangé à un polymère thermodurcissable dans un état métastable (pré-réticulé).

Le plastique dont est fait la première couche de plastique est sélectionné pour présenter une permittivité diélectrique maximale (typiquement supérieure à 6), comme précédemment expliqué.

La face du troisième stratifié 130 opposée à la quatrième couche conductrice 134 présente une pluralité de trous borgnes 138. Chaque trou borgne 138 est destiné à recevoir un second aimant 14. Un trou borgne 138 traverse la première couche de pré-imprégné 131 et la couche plastique 132, mais pas la seconde de pré-imprégné 133, ni la quatrième couche conductrice 134.

Le diamètre de chaque trou borgne 138 est plus important que le diamètre théorique d'un second aimant 14 de manière à ménager un intervalle latéral permettant d'absorber les dispersions de fabrication des seconds aimants et de positionnement de chaque trou borgne 138.

### Etape 340

L'étape 340 est l'étape d'encapsulation proprement dite permettant d'obtenir un composant 140. Le troisième stratifié 130 est approché par au-dessus de la couche d'espacement 112 portant les seconds aimants 14 de manière à loger chacun d'entre eux dans un trou borgne 138 correspondant.

Puis, est réalisée une opération de pressage sous vide et à température élevée (typiquement aux environs de 200°C) pour provoquer la polymérisation et assurer la prise du troisième stratifié 130, son collage sur la couche 112 et sur la face supérieure de chaque second aimant 14. Une couche isolante 142 est ainsi réalisée.

Le pressage permet de forcer le polymère des première et seconde couches de pré-imprégné, 131 et 133, dans les intervalles latéraux existants entre un second aimant 14 et le trou borgne 138 le recevant. Ainsi, l'aimant 14 est en contact sur toute sa face latérale avec le matériau de la couche isolante 142.

La présence de la seconde couche de pré-imprégné 133, qui est une couche continue, permet de compenser les éventuelles dispersion de fabrication sur la hauteur des seconds aimants 14. Ainsi, la distance entre les première et quatrième couches conductrices, 34 et 134, est maîtrisée.

### Etape 350

A ce stade du procédé 200, la réalisation des circulateurs à ferrite 160 dans l'épaisseur de la carte multicouche est terminée. Le procédé peut se poursuivre (étape 350) en empilant diverses couches de stratifié monocouche pour conférer à la carte de circuit imprimé multicouche (ou carte PCB selon l'anglais « Printed Circuit Board ») fabriquée d'autres fonctions, notamment la fonction d'élément rayonnant de l'antenne élémentaire.

Par exemple, dans la carte 150, obtenue à l'issue de l'étape 350, trois couches conductrices ont été ajoutées pour réaliser un élément rayonnant 180 : le circuit 154, obtenu par gravure de la quatrième couche conductrice 134 pour constituer un plan d'excitation connecté à l'extrémité d'une piste en « Y » 52 par un via 153 ; la couche 156 forme un plan de masse muni de fentes ; et la couche 158 est un plan rayonnant.

Les couches conductrices 154 et 156 d'une part et les couches conductrices 156 et 158 d'autre part sont séparées par des couches isolantes 155 et 157.

Des plots de connexion 152 sont réalisés sur les pistes 102 pour le raccordement (par l'intermédiaire de billes d'alliage de brasure, par exemple) à l'équipement dans lequel le composant élémentaire sera intégré.

L'étape 350 se termine de préférence par une découpe de la carte 150 réalisée de manière à isoler chaque composant élémentaire. Par exemple, la carte 150 est découpée pour obtenir trois composants élémentaires identiques, référencés 2, 4 et 6 sur la figure.

### Variantes de réalisation et Avantages

Dans le mode de réalisation présenté en détail ci-dessus, le circulateur à ferrite est composé d'une cellule gyromagnétique, d'un disque de ferrite en contact de la cellule gyromagnétique, et de premier et second aimants disposés de part et d'autres du disque de ferrite.

Le fait de disposer de deux aimants permet de guider les lignes de champ magnétique pour que ce dernier soit le plus homogène possible à la traversée du disque de ferrite et de la cellule gyromagnétique.

En variante, le circulateur comporte un nombre différent de disques de ferrite (par exemple deux disques de ferrite disposés de part et d'autre de la cellule gyromagnétique) et/ou un nombre différent d'aimants.

Dans encore une autre variante, l'un des deux aimants est remplacé par un élément magnétique, qui est réalisé dans un matériau permettant de forcer l'orientation des lignes du champ magnétique généré par l'autre aimant pour créer un champ homogène. Par exemple, cet élément magnétique est réalisé en acier.

Dans le mode de réalisation présenté en détail ci-dessus, le premier aimant (ou l'élément magnétique mis en œuvre à la place de ce premier aimant) est disposé à l'écart de la ferrite. La présence des vias métallisés entre la ferrite et ce premier aimant (ou ce l'élément magnétique) permet d'ajuster le couplage entre ces éléments. En variante, le premier aimant (ou l'élément magnétique mis en œuvre à sa place) est placé en contact direct de la ferrite.

L'homme du métier comprendra comment le procédé de fabrication présenté ci-dessus peut être adapté en fonction de la structure du circulateur à ferrite que l'on souhaite intégrer à la carte multicouche.

Avantageusement, pour éviter la démagnétisation du ou des aimants lors d'une étape d'encapsulation (la température à laquelle est portée le composant risquant alors de réduire fortement, voire de supprimer l'aimantation de l'aimant, si cette température est trop proche, voire supérieure à la température de Curie du matériau constitutif de l'aimant), le matériau constitutif de l'aimant et les matériaux constitutifs du stratifié sont sélectionnés pour que la température à atteindre pour la polymérisation du composite soit éloignée de la température de Curie de l'aimant. Par exemple, pour une température de polymérisation de 200°C, les aimants utilisés sont avantageusement en Samarium-Cobalt (SmCo), présentant une température de Curie de 450°C.

## Revendications

1. Procédé de fabrication (200) d'un composant (150) constitué d'une carte à circuit imprimé multicouche intégrant une pluralité de circulateurs à ferrite (160), le procédé comportant les étapes consistant à :
- préparer (210) une pluralité d'aimants (12) et une pluralité de disques de ferrite (10) ;
- coller (220) la pluralité de disques de ferrite (10) en surface sur une première couche conductrice (22) ;
- préparer (230) un premier stratifié (30) présentant, sur une face, des trous borgnes (38) et, sur une face opposée, une seconde couche conductrice (34) ;
- encapsuler (240) les disques de ferrite (10) dans le premier stratifié, chaque disque de ferrite étant reçu dans un trou borgne (38) correspondant ;
- graver (250) la première couche conductrice (22) pour y former une pluralité de cellules gyromagnétique (52), chaque cellule gyromagnétique étant située au droit d'un disque de ferrite (10) correspondant;
- coller (270) la pluralité d'aimants (12), chaque aimant étant placé au droit d'un disque de ferrite (10) correspondant ;
- préparer (280) un second stratifié (80), le second stratifié présentant, sur une face, des trous borgnes (88) et, sur une face opposée, une troisième couche conductrice (84) ;
- encapsuler (290) la pluralité d'aimants (12) dans le second stratifié (80) ; et,
- finaliser le composant (150),
la première couche conductrice (22) étant amincie avant d'y graver une pluralité de cellules gyromagnétiques (52).

2. Procédé selon la revendication 1, dans lequel encapsuler (240, 290) consiste à presser et polymériser le stratifié (30, 80) préparé.

3. Procédé selon la revendication 1 ou la revendication 2, dans lequel un stratifié (30, 80) comporte une seconde couche de pré-imprégné (33, 83) continue interposée entre chaque disque de ferrite (10) et la seconde couche conductrice (34) et entre chaque aimant (12) et la troisième couche conductrice (84).

4. Procédé selon l'une quelconque des revendications 1 à 3, dans lequel un stratifié (30, 80) comporte une couche de plastique (32, 82) présentant une permittivité diélectrique supérieure à 6.

5. Procédé selon l'une quelconque des revendications précédentes, dans lequel des vias métallisés (66) sont réalisés (260) pour établir une continuité électrique entre la seconde couche conductrice (34) et chaque disque de ferrite (10), la pluralité d'aimants étant collée sur la second couche conductrice.

6. Procédé selon l'une quelconque des revendications précédentes, **caractérisé en ce que**, les aimants étant des premiers aimants, le procédé comporte, en outre, les étapes consistant à :
- préparer (210) une pluralité de seconds éléments magnétiques (14) ;
- coller (320) la pluralité de seconds éléments magnétiques (14), chaque élément magnétique étant placé au droit d'un disque de ferrite (10) correspondant, de manière à ce que le disque de ferrite correspondant soit entre un premier aimant et un second élément magnétique ;
- préparer un troisième stratifié (130), le troisième stratifié présentant, sur une face, des trous borgnes (138) et, sur une face opposée, une quatrième couche conductrice (134); et,
- encapsuler (330) les seconds éléments magnétiques (14) dans le troisième stratifié (130).

7. Procédé selon l'une quelconque des revendications précédentes, comportant des étapes permettant d'intégrer dans la carte à circuit imprimé multicouche une fonctionnalité d'élément rayonnant, l'élément rayonnant étant connecté par un via métallisé à une extrémité d'une cellule gyromagnétique correspondante.

8. Procédé selon l'une quelconque des revendications précédentes, dans lequel chaque disque de ferrite est constitué d'une céramique de ferrite (15) dont les faces transversales sont recouvertes d'un film conducteur (16, 17).

9. Procédé selon l'une quelconque des revendications précédentes, dans lequel le collage de la pluralité de disques de ferrite (10), de la pluralité de premiers aimants et/ou de seconds éléments magnétiques met en œuvre un bras robotisé afin d'obtenir un positionnement précis par rapport à un repère de référence.

10. Procédé selon l'une quelconque des revendications précédentes, comportant une étape finale de découpe de la carte à circuit imprimé multicouche pour obtenir une pluralité de composants élémentaires.

## Patentansprüche

1. Verfahren zur Herstellung (200) einer Komponente (150), die aus einer mehrschichtigen Leiterplatte besteht, die eine Vielzahl von Ferritzirkulatoren (160) integriert, das Verfahren umfassend die Schritte, die aus Folgendem bestehen:
- Vorbereiten (210) einer Vielzahl von Magneten (12) und einer Vielzahl von Ferritscheiben (10);
- Kleben (220) der Vielzahl von Ferritscheiben (10) an der Oberfläche auf eine erste leitende Schicht (22);
- Vorbereiten (230) eines ersten Laminats (30), das auf einer Seite Sacklöcher (38) und auf einer gegenüberliegenden Seite eine zweite leitende Schicht (34) aufweist;
- Einkapseln (240) der Ferritscheiben (10) in das erste Laminat, wobei jede Ferritscheibe in einem entsprechenden Sackloch (38) aufgenommen ist;
- Ätzen (250) der ersten leitenden Schicht (22), um darin eine Vielzahl von gyromagnetischen Zellen (52) zu bilden, wobei sich jede gyromagnetische Zelle an einer entsprechenden Ferritscheibe (10) befindet;
- Kleben (270) der Vielzahl von Magneten (12), wobei jeder Magnet direkt neben einer entsprechenden Ferritscheibe (10) platziert wird;
- Vorbereiten (280) eines zweiten Laminats (80), wobei das zweite Laminat auf einer Seite Sacklöcher (88) und auf einer gegenüberliegenden Seite eine dritte leitende Schicht (84) aufweist;
- Einkapseln (290) der Vielzahl von Magneten (12) in dem zweiten Laminat (80); und
- Fertigstellen der Komponente (150),
wobei die erste leitende Schicht (22) vor dem Ätzen einer Vielzahl von gyromagnetischen Zellen (52) verdünnt wird.

2. Verfahren nach Anspruch 1, wobei das Einkapseln (240, 290) darin besteht, das vorbereitete Laminat (30, 80) zu pressen und zu polymerisieren.

3. Verfahren nach Anspruch 1 oder 2, wobei ein Laminat (30, 80) eine durchgehende zweite Prepreg-Schicht (33, 83) umfasst, die zwischen jede Ferritscheibe (10) und die zweite leitende Schicht (34) und zwischen jeden Magneten (12) und die dritte leitende Schicht (84) eingefügt ist.

4. Verfahren nach einem der Ansprüche 1 bis 3, wobei ein Laminat (30, 80) eine Kunststoffschicht (32, 82) umfasst, die eine dielektrische Dielektrizitätskonstante von mehr als 6 aufweist.

5. Verfahren nach einem der vorherigen Ansprüche, wobei metallisierte Durchkontaktierungen (66) hergestellt werden (260), um einen elektrischen Durchgang zwischen der zweiten leitenden Schicht (34) und jeder Ferritscheibe (10) herzustellen, wobei die Vielzahl von Magneten auf die zweite leitende Schicht geklebt wird.

6. Verfahren nach einem der vorherigen Ansprüche, **dadurch gekennzeichnet, dass**, da die Magnete erste Magnete sind, das Verfahren ferner die Schritte umfasst, die aus Folgendem bestehen:
- Vorbereiten (210) einer Vielzahl von zweiten magnetischen Elementen (14);
- Kleben (320) der Vielzahl von zweiten magnetischen Elementen (14), wobei jedes magnetische Element an einer entsprechenden Ferritscheibe (10) platziert ist, sodass die entsprechende Ferritscheibe zwischen einem ersten magnetischen Element und einem zweiten magnetischen Element ist;
- Vorbereiten eines dritten Laminats (130), wobei das dritte Laminat auf einer Seite Sacklöcher (138) und auf einer gegenüberliegenden Seite eine vierte leitende Schicht (134) aufweist; und
- Einkapseln (330) der zweiten magnetischen Elemente (14) in dem dritten Laminat (130).

7. Verfahren nach einem der vorherigen Ansprüche, umfassend Schritte, die es ermöglichen, in die mehrschichtige Leiterplatte eine Strahlerelementfunktionalität zu integrieren, wobei das Strahlerelement durch eine metallisierte Durchkontaktierung mit einem Ende einer entsprechenden gyromagnetischen Zelle verbunden ist.

8. Verfahren nach einem der vorherigen Ansprüche, wobei jede Ferritscheibe aus einer Ferritkeramik (15) besteht, deren Querflächen mit einem leitenden Film (16, 17) bedeckt sind.

9. Verfahren nach einem der vorherigen Ansprüche, wobei beim Kleben der Vielzahl von Ferritscheiben (10), der Vielzahl von ersten Magneten und/oder zweiten magnetischen Elementen ein Roboterarm eingesetzt wird, um eine genaue Positionierung in Bezug auf eine Referenzmarkierung zu erlangen.

10. Verfahren nach einem der vorherigen Ansprüche, umfassend einen abschließenden Schritt eines Zuschneidens der mehrschichtigen Leiterplatte, um eine Vielzahl von elementaren Komponenten zu erlangen.

## Claims

1. A manufacturing method (200) of a component (150) constituted of a multilayer printed circuit board integrating a plurality of ferrite circulators (160), the method including the steps consisting of:
- preparing (210) a plurality of magnets (12) and a plurality of ferrite disks (10);
- bonding (220) the plurality of ferrite disks (10) on the surface onto a first conductive layer (22);
- preparing (230) a first laminate (30) presenting, on one face, blind holes (38) and, on an opposite face, a second conductive layer (34);
- encapsulating (240) the ferrite disks (10) in the first laminate, each ferrite disk being received in a corresponding blind hole (38);
- etching (250) the first conductive layer (22) in order to form thereon a plurality of gyromagnetic cells (52), each gyromagnetic cell being located in line with a corresponding ferrite disk (10);
- bonding (270) the plurality of magnets (12), each magnet being in line with a corresponding ferrite disk (10);
- preparing (280) a second laminate (80), the second laminate presenting, on one face, blind holes (88) and, on an opposite face, a third conductive layer (84);
- encapsulating (290) the plurality of magnets (12) in the second laminate (80); and
- finalizing the component (150),
the first conductive layer (22) being thinned before etching therein a plurality of gyromagnetic cells (52).

2. The method according to claim 1, wherein encapsulating (240, 290) comprises pressing and polymerizing the prepared laminate (30, 80).

3. The method according to claim 1 or claim 2, wherein a laminate (30, 80) includes a second continuous prepreg layer (33, 83) interposed between each ferrite disk (10) and the second conductive layer (34) and between each magnet (12) and the third conductive layer (84).

4. The method according to any one of claims 1 to 3, wherein a laminate (30, 80) includes a plastic layer (32, 82) presenting a dielectric permittivity greater than 6.

5. The method according to any one of the preceding claims, wherein metallized vias (66) are realized (260) to establish electrical continuity between the second conductive layer (34) and each ferrite disk (10), the plurality of magnets being bonded onto the second conductive layer.

6. The method according to any one of the preceding claims, **characterized in that**, the magnets being first magnets, the method includes, in addition, the steps consisting of:
- preparing (210) a plurality of second magnetic elements (14);
- bonding (320) the plurality of second magnetic elements (14), each magnetic element being in line with a corresponding ferrite disk (10), in such a way that the corresponding ferrite disk is between a first magnet and a second magnetic element;
- preparing a third laminate (130), the third laminate presenting, on one face, blind holes (138) and, on an opposite face, a fourth conductive layer (134); and
- encapsulating (330) the second magnetic elements (14) in the third laminate (130).

7. The method according to any one of the preceding claims, including steps allowing to integrate into the multilayer printed circuit board a radiating element functionality, the radiating element being connected by a metallized via to one end of a corresponding gyromagnetic cell.

8. The method according to any one of the preceding claims, wherein each ferrite disk is constituted of a ferrite ceramic (15) the transverse faces of which are covered with a conductive film (16, 17).

9. The method according to any one of the preceding claims, wherein the bonding of the plurality of ferrite disks (10), of the plurality of first magnets and/or second magnetic elements implements a robot arm in order to obtain precise positioning relative to a reference marker.

10. The method according to any one of the preceding claims, including a final step of cutting the multilayer printed circuit board to obtain a plurality of elementary components.
